# EUROPEAN PATENT SPECIFICATION

(11) **EP 4 489 303 B1**
(45) Date of publication and mention of the grant of the patent: **24.06.2026**
(21) Application number: 23182977.1
(22) Date of filing: 03.07.2023
(51) Int. Cl.: H03K 17/0812, H03K 17/082

(54) **OVERVOLTAGE PROTECTION OF TRANSISTOR SWITCHES**
ÜBERSPANNUNGSSCHUTZ FÜR TRANSISTORSCHALTER
PROTECTION CONTRE LES SURTENSIONS DE COMMUTATEURS À TRANSISTORS

(43) Date of publication of application: 08.01.2025
(73) Proprietor: Nexperia B.V., 6534 AB Nijmegen (NL)
(72) Inventor: Lookman, Paulo, Nijmegen (FI); Philpott, Justin, Bedford (US); Zeelen, Patrick, Nijmegen (NL)
(74) Representative: Pjanovic, Ilija

(56) References cited:
- US-A1- 2009 027 110
- US-A1- 2023 040 189

## Description

### Technical field

The present disclosure relates to electronic circuits for overvoltage protection to limits the voltages on an electronic load which is controlled with an electronic switch, in particular applicable for eFuse circuits.

### Background

N-Channel Metal-Oxide-Semiconductor Field-Effect Transistors (NMOS FET) and P-Channel Metal-Oxide-Semiconductor Field-Effect Transistors (PMOS FET) are types of transistors that uses NMOS or PMOS as the conducting channel. NMOS and PMOS FETs are commonly used in digital and analog circuits for various applications such as switching, amplification, and signal routing.

The core component of an NMOS switch is an n-channel MOSFET, which typically includes a drain terminal (connected to the input signal), a source terminal (connected to the output), and a gate terminal. The gate terminal controls the conduction of current through the channel. It is electrically insulated from the channel by a thin layer of oxide, typically made of silicon dioxide (SiO₂).

When a voltage is applied to the gate terminal, it creates an electric field that forms a conducting channel between the drain and source regions. The channel allows current to flow from the drain to the source. The amount of current that flows through the channel is controlled by the voltage applied to the gate terminal.

In an NMOS switch configuration, the source terminal may be connected to a load (output), while the drain terminal is connected to a supply (input). A control signal may be applied to the gate terminal. When the gate source voltage is sufficiently high, the NMOS switch turns "on," allowing current to flow from the drain to the source, thereby passing the supply voltage to the output. In an NMOS switch configuration the gate voltage is higher than the supply voltage (NMOS FET is "on"). If the gate voltage is low, the NMOS switch turns "off," and little to no current flows from the drain to the source, effectively blocking the supply voltage. Such NMOS switch may be referred to as NMOS pass FET.

A charge pump is a circuit that may be used to generate a higher voltage level than the input voltage. In the context of an NMOS pass FET, a charge pump can be used to provide the required gate voltage for the FET to turn "on" and allow current to flow through it.

An NMOS transistor (NMOST) switch, such as an NMOS pass FET, or a PMOS transistor (PMOST) switch, such as a PMOS pass FET, may include a sensing and protection circuit for preventing output overvoltage or overcurrent through the switch. Such protection circuit can be implemented inside an eFuse. An overvoltage clamp, also known as a voltage clamp or overvoltage protection, is a mechanism that can be used to limit the voltage across electronic component controlled with an electronic switch. It ensures that the voltage does not exceed a certain threshold, protecting the component from potential damage caused by excessive voltage levels. In the context of a pass FET, an overvoltage clamp may be implemented to prevent the source voltage (Vsource) from reaching values that could harm the electronic load or cause it to malfunction. The overvoltage clamp circuit is typically designed to limit the voltage at the source terminal to a safe level.

A prior art overvoltage protection circuit can be studied in US 2009/027110 A1.

### Summary

The present disclosure aims to provide an eFuse circuit for a transistor switch, such as an NMOST switch or a PMOST switch, with overvoltage protection, wherein the overvoltage circuit is functionally independent of the eFuse load impedance, load current and load capacitance.

According to an aspect of the present disclosure, an electronic circuit is presented for overvoltage protection of a transistor switch. The electronic circuit may include an overvoltage comparator configured to detect an overvoltage on a source voltage of the transistor switch by comparing the source voltage to a reference voltage. The overvoltage comparator may further be configured to output an on signal when overvoltage is detected. The electronic circuit may include a switch configured to be switched on by the on signal. The electronic circuit may include a voltage regulator configured to regulate a clamp voltage when the switch is switched on. The clamp voltage may regulate a gate voltage on a gate of the transistor switch. The electronic circuit may include a further comparator configured to detect an input voltage of the transistor switch. The further comparator may further be configured to output an off signal when the input voltage is below a threshold voltage. The switch may further be configured to be switched off by the off signal. The voltage regulator and the further comparator may be switched off when the switch is switched off.

In an embodiment, the electronic circuit may further include a fast discharge circuit configured to fast discharge a gate-source capacitance of the transistor switch. The fast discharge circuit may be configured to be active at the start of an overvoltage event triggered by the on signal.

In an embodiment, the electronic circuit may further include an undershoot protection transistor. A drain of the undershoot protection transistor may be connected to the input voltage. A source of the undershoot protection transistor may be connected to the gate of the transistor switch via the switch. A gate of the undershoot protection transistor may be connected to the claim voltage.

In an embodiment, the transistor switch may be an NMOST switch (high side).

In an embodiment, the transistor switch may be a PMOST switch (low side).

In an embodiment, the overvoltage comparator and the further comparator may be Schmitt-trigger comparators.

In an embodiment, the gate of the transistor switch may be connected to a charge pump. The charge pump may operate independently from the switch.

In an embodiment, the electronic circuit may be a part of an eFuse circuit for overvoltage protection of an electronic load. The eFuse circuit may be configured to be switched on and off by the switch under control of the on signal and the off signal, with exception of the overvoltage comparator which may be active irrespectively of the switch being on or off.

According to an aspect of the present disclosure, an electronic device is presented. The electronic device may include an electronic circuit and a transistor switch having one or more of the above-described features.

A summary of aspects of certain examples disclosed herein is set forth below. It should be understood that these aspects are presented merely to provide the reader with a brief summary of these certain embodiments and that these aspects are not intended to limit the scope of this disclosure. The scope of protection is defined solely by the appended claims.

### Brief description of the Drawings

Embodiments of the present disclosure will now be described, by way of example only, with reference to the accompanying schematic drawings in which corresponding reference symbol indicate corresponding parts, in which:
Fig. 1 shows a simplified example schematic drawing of an electronic circuit including an NMOST switch and a charge pump;
Fig. 2 shows an example schematic drawing of an electronic circuit with an NMOST switch and including an overvoltage protection circuit;
Fig. 3 shows another example schematic drawing of an electronic circuit with an NMOST switch and including an overvoltage protection circuit;
Fig. 4 shows another example schematic drawing of an electronic circuit with an NMOST switch and including an overvoltage protection circuit;
Figs. 5-7 show examples of eFuse overvoltage protection topologies, according to embodiments of the present disclosure; and
Fig. 8 illustrated an electronic device including an electronic circuit for overvoltage protection of a transistor switch, according to an embodiment of the present disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure can be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

For an eFuse with an NMOST switch, such as an NMOS pass FET, driven by a charge pump, the output is to be limited during an input overvoltage event. Hereto, the circuit may clamp the output voltage to a fixed level. The overvoltage circuit is preferably functionally independent of the eFuse load impedance, load current and load capacitance (with load current typically from micro-Amps to Amps and load capacitance typically from micro-Farad to milli-Farad). The present application provides a system that can clamp the output voltage to a fixed level by sensing the output voltage and enables auto correction for process, current load and temperature.

In the following, examples circuits are shown including an NMOST switch. The present disclosure is not limited to NMOST switches and may be applied to transistor switches in general, e.g., to PMOST switches, with the required modifications to the circuits, such as changing the voltages applied to Vcc and Vsource and as known per se. An example of an NMOST switch is an NMOS pass FET. An example of a PMOST switch is a PMOS pass FET.

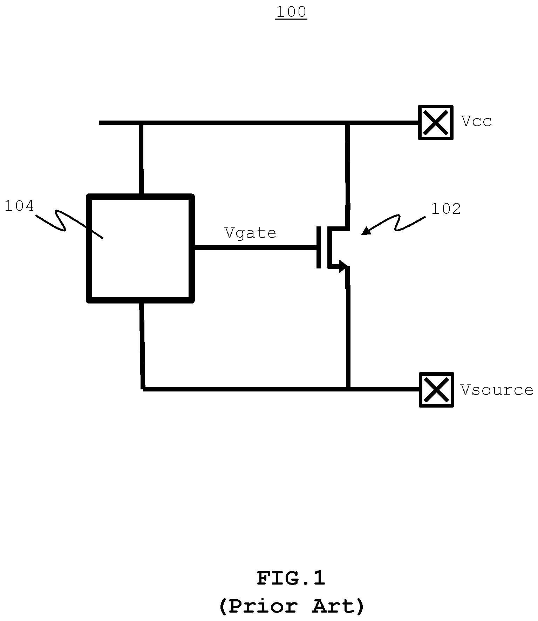

Fig. 1 shows a simplified example schematics of an electronic circuit 100 including an NMOS pass FET 102 and a charge pump 104. Vcc may be connected to the drain of the NMOS pass FET 102 and the charge pump 104. The charge pump 104 may further receive the output voltage (Vout) of the NMOS pass FET 102 to control the gate voltage Vgate 102. Vgate may be used for switching the NMOS pass FET 102 "on" and "off".

An eFuse may protect the load when a large overshoot occurs at the input of the eFuse. In an example embodiment, the input rise time may be targeted to be <1V/µs.

To detect an overvoltage, the e-Fuse may sense the input supply (Vcc), the output voltage (Vsource) or both.

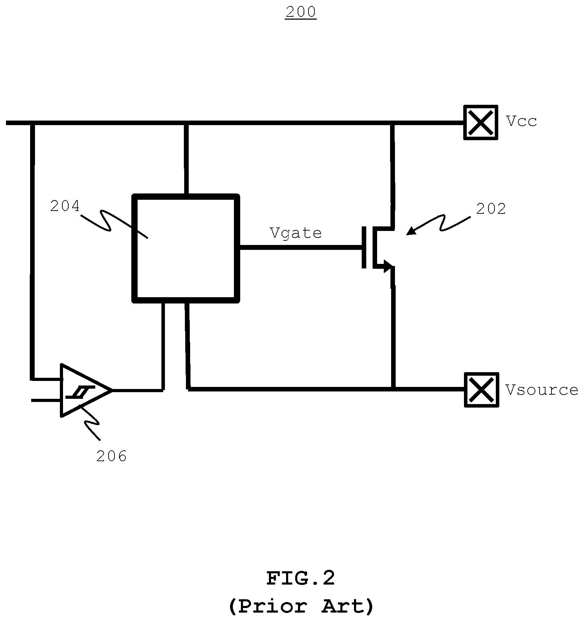

Fig. 2 shows an example simplified schematics 200 of an eFuse implementation for monitoring the input supply Vcc. In Fig. 2, an NMOST switch 202, a charge pump 204 providing Vgate to the NMOST switch 202, and a comparator 206 are shown. The comparator 206 is, e.g., a Schmitt-trigger comparator.

After detecting an overvoltage on Vcc, a "regulation" loop may be activated to clamp the output voltage to a fixed value. An internal voltage may be used to clamp the gate of the NMOST switch 202 to a fixed value to limit the output voltage. When Vcc drops below the clamp voltage, the overvoltage clamp may be deactivated.

Disadvantageously, in the eFuse circuit of Fig. 2, the output voltage clamp voltage will typically be dependent on the load current and on the temperature (e.g., in a Vgs NMOS switch).

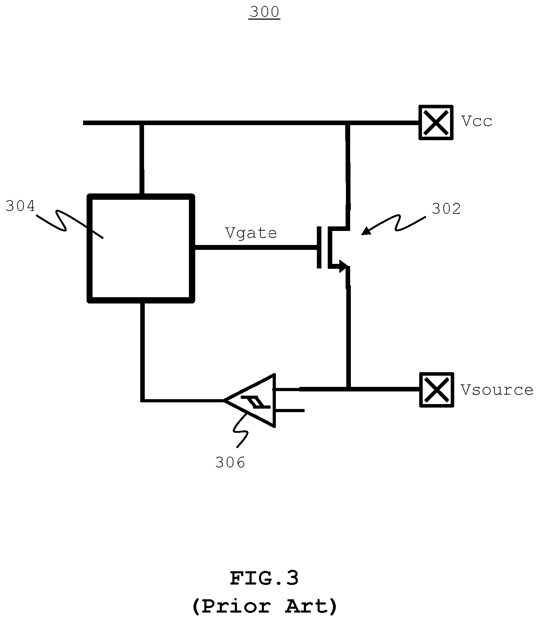

Fig. 3 shows an example simplified schematics 300 of an eFuse implementation for monitoring the output voltage Vsource. In Fig. 3, an NMOST switch 302, a charge pump 304 providing Vgate to the NMOST switch 302, and a comparator 306 are shown. The comparator 306 is, e.g., a Schmitt-trigger comparator.

After detecting an overvoltage on Vsource, a "regulation" loop may be activated to clamp the output voltage to a fixed value. An internal voltage may be used to clamp the gate of the NMOST switch 302 to a fix value to limit the output voltage. The output voltage clamp voltage will typically be depending on the load current and on the temperature (e.g., in a Vgs NMOST switch), however the sensing structure makes it possible to correct the output clamp voltage.

Disadvantageously, in the eFuse circuit of Fig. 3, a sensing structure (on the input) is needed to determine when to release the clamp.

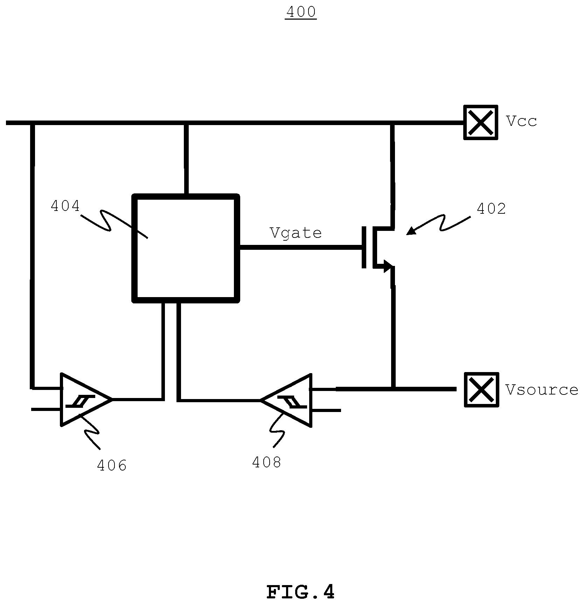

Fig. 4 shows an example simplified schematics 400 of an eFuse implementation for monitoring the input supply Vcc and the output voltage Vsource. In Fig. 4, an NMOST switch 402, a charge pump 404 providing Vgate to the NMOST switch 402, and two comparators 406, 408 are shown. The comparators 406, 408 are, e.g., Schmitt-trigger comparators.

After detecting an overvoltage on the input Vcc or output Vsource, a "regulation" loop may be activated to clamp the output voltage to a fixed value. The output voltage clamp voltage will typically be depending on the load current and on the temperature (e.g., in a Vgs NMOS switch), however the source sensing structure makes it possible to correct the output clamp voltage. When Vcc drops below the clamp voltage, the overvoltage clamp may be deactivated.

In the eFuse circuit of Fig. 4, the clamp voltage may be made independent of the load current and the clamp may be fully released when the supply voltage is back to "normal".

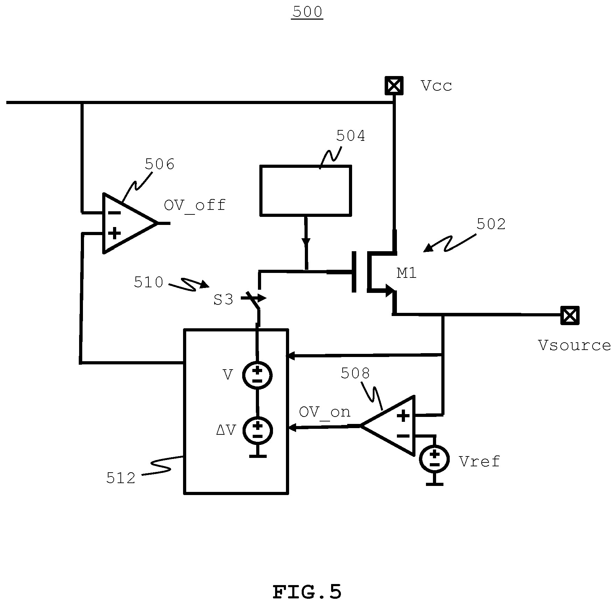

Fig. 5 shows an eFuse overvoltage protection topology 500 of an example embodiment of the present application. In Fig. 5, an NMOST switch (M1) 502, a charge pump 504 providing Vgate to the NMOST switch 502, two comparators 506, 508, a switch (S3) 510 and a voltage regulator 512 are shown. The comparators 506, 508 are, e.g., Schmitt-trigger comparators.

The overvoltage protection topology 500 enables an overvoltage clamp with source monitoring for overvoltage detection and release, with source voltage clamp correction. In this example, NMOST switch 502 is a large transistor, e.g., with Gm > 40mA/mV. The load current may vary, e.g., from 0 to 15A, and Vgs may vary, e.g., from Vth to Vth+0.4V, Vth being the threshold voltage.

Comparator 508 may detect an overvoltage by comparing Vsource with a reference voltage Vref. When overvoltage is detected, the comparator 508 may output a signal indicating the detection of the overvoltage, e.g., by outputting a voltage indicating a "high" signal. At overvoltage, the switch 510 may be closed and Vgate for the NMOST switch 502 may be fixed to a voltage VG_set from a voltage source V in the voltage regulator 512.

The VG_set may be corrected to reduce the spread of the clamped (direct current, DC) output voltage Vsource.

For stability and to be insensitive for the output (dynamic) load, the VG_set may have a limited regulation range. For example, VG_set may have a correction range for spread Vgs of -1V to +1V, which may be controlled by a correction voltage source ΔV in the voltage regulator 512.

The charge pump 504 may be used to have a VG_set higher than Vcc.

In a non-limiting example, a Vref may be set to 14.5V. When comparator 508 detects that Vsource>Vref (14.5V), comparator 508 may output an overvoltage on signal. When overvoltage is on (e.g., comparator 508 outputs a high signal OV_on), the switch 510 may be closed and Vsource may be "regulated" by the voltage regulator 512 to Vclamp (e.g., 14.5V). When Vsource<Vclamp (e.g., 14.3V) and comparator 506 detects that Vcc<Vdetect, there is no overvoltage anymore and the switch 510 may be opened triggered by a signal, e.g., OV_off, from the comparator 506.

Advantageously, when overvoltage is off, all eFuse circuits 506, 512 may be turned off when switching off the switch (S3) 510, except for the overvoltage detection comparator 508 to enable overvoltage detection on Vsource. Thus advantageously, when there is no overvoltage, no load impedance, load current or load capacitance is applied to the NMOST switch (M1) 502 from the eFuse circuits.

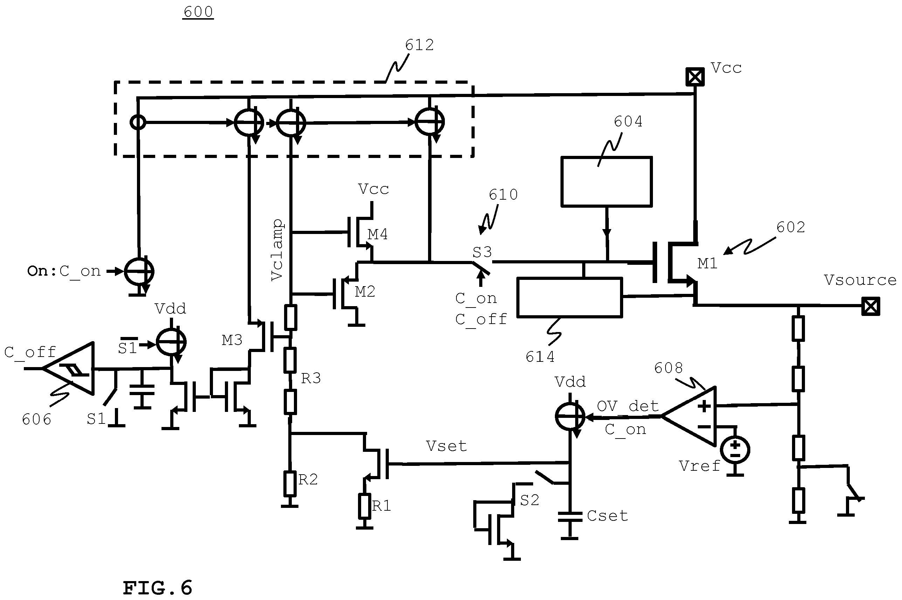

Fig. 6 shows a more detailed eFuse overvoltage protection topology 600 of an example embodiment of the present application. In Fig. 6, an NMOST switch (M1) 602, a charge pump 604 providing Vgate to the NMOST switch 602, two comparators 606, 608, a switch (S3) 610, a current mirror 612, a fast-discharging circuit 614, further transistor switches M2-M4, further switches S1-S2, resistors R1-R3 and a capacitance Cset are shown. Further electronic components (resistors, capacitors, transistors, power sources) are shown without being labeled. The comparators 606, 608 are, e.g., Schmitt-trigger comparators.

The eFuse topology 600 of Fig. 6 operates similar to the simplified eFuse topology 500 of Fig. 5. Comparator 608 may detect an overvoltage on Vsource. When overvoltage is detected, the comparator 608 may output an OV_det signal, which may trigger a "clamp on" (C_on) signal to be output. The OV_det and C_on signal may be one and the same signal, e.g., a 5V output or any other output signal. The C_on signal triggers the switch (S3) 610 to be closed, current mirror 612 switched on, and capacitor Cset may start charging.

Optionally, and as shown in the example of Fig. 6, the C_on signal may further trigger a fast discharge via the fast-discharging circuit 614. The gate-source capacitance, Cgs, of the NMOST switch (M1) 602 may thus be fast discharged, e.g., from about 5V to about 1V, and remaining energy from the NMOST switch (M1) 602 may flow to ground via transistor M2. The fast discharge is typically only active at the start of the overvoltage event triggered by C_on, i.e., it may have a short activation pulse.

Transistor M4 may enable undershoot protection, to prevent Vgate of the NMOST switch (M1) 602 to drop too low during a fast discharge.

The gate of the NMOST switch (M1) 602 may be connected to the clamping voltage Vclamp via the switch (S3) 610 and a transistor M2 operating as source follower. The Vclamp may start with the highest reference voltage.

As long the comparator 608 is high (i.e., detects an overvoltage and outputs OV_det), Vclamp may be regulated down through charging up Vset until the comparator 608 releases the OV detection (i.e., no more overvoltage detection and stops outputting OV_det). In the example of Fig. 6, the Vclamp voltage range may be regulated from I x (R3+R2) to I x (R3+R2//R1).

The source of transistor M3 may sense the Vcc voltage. When transistor M3 stops conducting, the overvoltage clamp may be released. Comparator 606 may then be triggered and output a "clamp off" (C_off) signal. The C_off signal may trigger the switch (S3) 610 to be opened and capacitor Cset may be discharged. The C_off signal may be the same as the OV_off signal in Fig. 5.

Advantageously, and similar to the example of Fig. 5, when overvoltage is off, all eFuse circuits 606, 612, 614 may be turned off when switching off the switch (S3) 610, except for the overvoltage detection comparator 608 to enable overvoltage detection on Vsource. Thus advantageously, when there is no overvoltage, no load impedance, load current or load capacitance is applied to the NMOST switch (M1) 602 from the eFuse circuits.

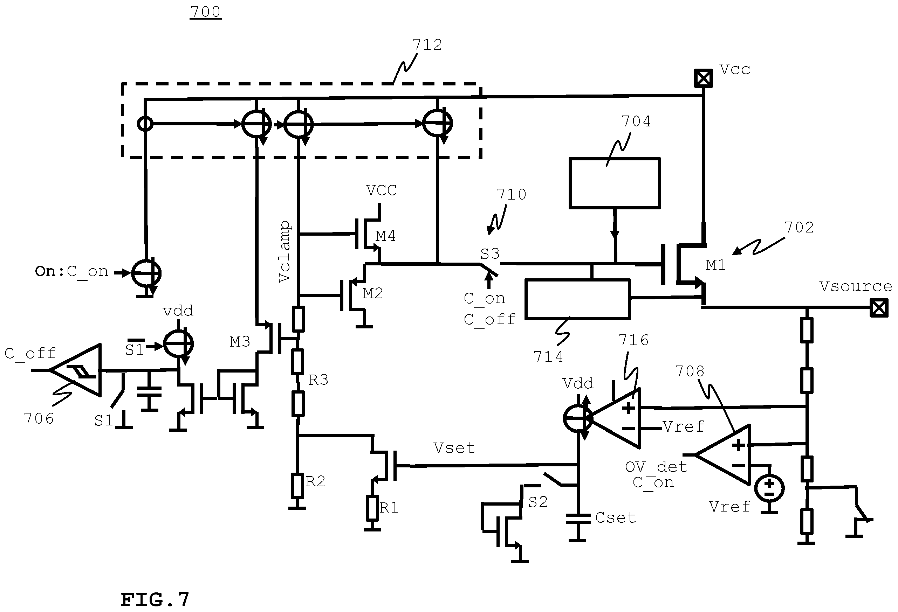

Fig. 7 shows a more detailed eFuse overvoltage protection topology 700 of another example embodiment of the present application. In Fig. 7, an NMOST switch (M1) 702, a charge pump 704 providing Vgate to the NMOST switch 702, three comparators 706, 708, 716, a switch (S3) 710, a current mirror 712, a fast discharging circuit 714, further transistor switches M2-M4, further switches S1-S2, resistors R1-R3 and a capacitance Cset are shown. Further electronic components (resistors, capacitors, transistors, power sources) are shown without being labeled. The comparators 706, 708 are, e.g., Schmitt-trigger comparators.

The eFuse topology 700 is similar to the eFuse topology 600 of Fig. 6, with the exception of the additional comparator 716 next to the overvoltage comparator 708.

Comparator 708 may detect an overvoltage on Vsource. When overvoltage is detected, the comparator 708 may output an OV_det signal, which may trigger a "clamp on" (C_on) signal to be output. The OV_det and C_on signal may be one and the same signal, e.g., a 5V output or any other output signal. The C_on signal triggers the switch (S3) 710 to be closed and capacitor Cset may start charging.

Optionally, and as shown in the example of Fig. 7, the C_on signal may further trigger a fast discharge via the fast-discharging circuit 714. The gate-source capacitance, Cgs, of the NMOST switch (M1) 702 may thus be fast discharged, e.g., from about 5V to about 1V, and remaining energy from the NMOST switch (M1) 702 may flow to ground via transistor M2. The fast discharge is typically only active at the start of the overvoltage event triggered by C_on, i.e., it may have a short activation pulse.

Transistor M4 may enable undershoot protection, to prevent Vgate of the NMOST switch (M1) 702 to drop too low during a fast discharge.

The gate of the NMOST switch (M1) 702 may be connected to the clamping voltage Vclamp via the switch (S3) 710 and a transistor M2 operating as source follower. The Vclamp may start with the highest reference voltage.

The clamp reference voltage may continuously be corrected by the comparator 716, which compares Vsource with Vref and adjusts Vset accordingly until the comparator 708 releases the OV detection (i.e., no more overvoltage detection and stops outputting OV_det). Thus, an overvoltage claim with Vgs correction for the NMOST switch (M1) 702 may be achieved. In the example of Fig. 7, the Vclamp voltage range may be regulated from I x (R3+R2) to I x (R3+R2//R1).

The source of transistor M3 may sense the Vcc voltage. The gate voltage of M3 may follow the regulated clamp voltage. When Vcc goes to the OV release level, Vclamp may be regulated up to maintain the Vsource clamp voltage, increasing the M3 source voltage. When transistor M3 stops conducting, the overvoltage clamp may be released. Comparator 706 may then be triggered and output a "clamp off" (C_off) signal. The C_off signal may trigger the switch (S3) 710 to be opened and capacitor Cset may be discharged. The C_off signal may be the same as the OV_off signal in Fig. 5.

Advantageously, and similar to the examples of Fig. 5 and Fig. 6, when overvoltage is off, all eFuse circuits may be turned off by switching off the switch (S3) 710, except for the overvoltage detection comparator 708 to enable overvoltage detection on Vsource. Thus advantageously, when there is no overvoltage, no load impedance, load current or load capacitance is applied to the NMOST switch (M1) 702 from the eFuse circuits.

As shown in the examples of Figs. 5-7, advantageously the eFuse solution of the present disclosure enables a low current consumption in normal operation when there is no overvoltage being detected. Only the overvoltage comparator 508, 608, 708 of the eFuse circuit is active when there is no overvoltage.

As shown in the examples of Figs. 6 and 7, fast activation of the overvoltage circuit may be achieved when applying fast discharging. By applying fast discharging, e.g., using a fast-discharging circuit 614, 714, the clamping delay may become mainly depending on the discharging of the NMOST switch (M1) 602, 702.

The present application, such as shown in the example eFuse topologies of Figs. 5-7, advantageously allows for correction for output load current, temperature and process (Vgs variation correction).

The present application, such as shown in the example eFuse topologies of Figs. 5-7, advantageously enables the voltage correction range to be limited through a voltage regulator 512. This may ensure that there is no large overshoot or undershoot of Vsource when applying the voltage clamp.

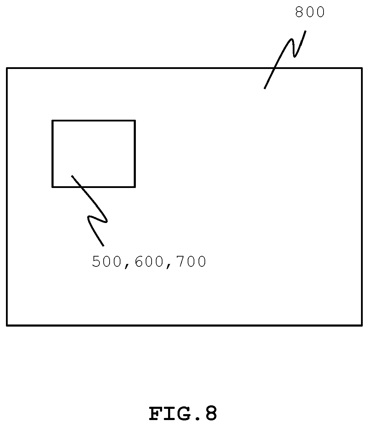

As illustrated in Fig. 8, electronic circuit of the eFuse overvoltage protection topology of the present disclosure, such as the electronic circuit of the eFuse overvoltage protection topology 500, 600, 700 (including the NMOST switch (M1) 502, 602, 702) may be implemented in or part of any device 800 that uses a transistor switch such as the NMOST switch (M1) 502, 602, 702.

## Claims

1. An electronic circuit (500, 600, 700) for overvoltage protection of a transistor switch (502, 602, 702), comprising:
an overvoltage comparator (508, 608, 708) configured to detect an overvoltage on a source voltage (Vsource) of the transistor switch (502, 602, 702) by comparing the source voltage (Vsource) to a reference voltage (Vref), and further configured to output an on signal (OV_on, C_on) when overvoltage is detected;
a switch (510, 610, 710) configured to be switched on by the on signal (OV_on, C_on);
a voltage regulator (512) configured to regulate a clamp voltage (Vclamp) when the switch (510, 610, 710) is switched on, wherein the clamp voltage (Vclamp) regulates a gate voltage (Vgate) on a gate of the transistor switch (502, 602, 702); and
a further comparator (506, 606, 706) configured to detect an input voltage (Vcc) of the transistor switch (502, 602, 702), and further configured to output an off signal (OV_off, C_off) when the input voltage (Vcc) is below a threshold voltage,
wherein the switch (510, 610, 710) is further configured to be switched off by the off signal (OV_off, C_off), and
wherein the voltage regulator (512) and the further comparator (506, 606, 706) are switched off when the switch (510, 610, 710) is switched off.

2. The electronic circuit (500, 600, 700) according to claim 1, further comprising a fast discharge circuit (614, 714) configured to fast discharge a gate-source capacitance of the transistor switch (502, 602, 702) , wherein the fast discharge circuit is configured to be active at the start of an overvoltage event triggered by the on signal (V_on, C_on).

3. The electronic circuit (500, 600, 700) according to any one of the preceding claims, further comprising an undershoot protection transistor (M4), wherein a drain of the undershoot protection transistor (M4) is connected to the input voltage (Vcc), wherein a source of the undershoot protection transistor (M4) is connected to the gate of the transistor switch (502, 602, 702) via the switch (510, 610, 710), and wherein a gate of the undershoot protection transistor (M4) is connected to the claim voltage (Vclamp).

4. The electronic circuit (500, 600, 700) according to any one of the claims 1-3, wherein the transistor switch (502, 60, 702) is an NMOST switch.

5. The electronic circuit (500, 600, 700) according to any one of the claims 1-3, wherein the transistor switch (502, 60, 702) is a PMOST switch.

6. The electronic circuit (500, 600, 700) according to any one of the preceding claims, wherein the overvoltage comparator (508, 608, 708) and the further comparator (506, 606, 706) are Schmitt-trigger comparators.

7. The electronic circuit (500, 600, 700) according to any one of the preceding claims, wherein the gate of the transistor switch (502, 602, 702) is connected to a charge pump (504), wherein the charge pump (504) operates independently from the switch (510, 610, 710).

8. The electronic circuit (500, 600, 700) according to any one of the preceding claims, wherein the electronic circuit (500, 600, 700) is a part of an eFuse circuit for overvoltage protection of an electronic load, wherein the eFuse circuit is configured to be switched on and off by the switch (510, 610, 710) under control of the on signal (OV_on, C_on) and the off signal (OV_off, C_off), with exception of the overvoltage comparator (508, 608, 708) which is active irrespectively of the switch (510, 610, 710) being on or off.

9. An electronic device (800) comprising an electronic circuit (500, 600, 700) and a transistor switch (502, 602, 702) according to any one of the claims 1-8.

## Patentansprüche

1. Elektronische Schaltung (500, 600, 700) zum Überspannungsschutz eines Transistorschalters (502, 602, 702), umfassend:
einen Überspannungskomparator (508, 608, 708), der konfiguriert ist, um eine Überspannung an einer Source-Spannung (Vsource) des Transistorschalters (502, 602, 702) durch Vergleichen der Source-Spannung (Vsource) mit einer Referenzspannung (Vref) zu erkennen, und der ferner konfiguriert ist, um ein Ein-Signal (OV_on, C_on) auszugeben, wenn eine Überspannung erkannt wird;
einen Schalter (510, 610, 710), der konfiguriert ist, um durch das Ein-Signal (OV_on, C_on) eingeschaltet zu werden;
einen Spannungsregler (512), der konfiguriert ist, um eine Klemmspannung (Vclamp) zu regeln, wenn der Schalter (510, 610, 710) eingeschaltet ist, wobei die Klemmspannung (Vclamp) eine Gate-Spannung (Vgate) an einem Gate des Transistorschalters (502, 602, 702) regelt; und
einen weiteren Komparator (506, 606, 706), der konfiguriert ist, um eine Eingangsspannung (Vcc) des Transistorschalters (502, 602, 702) zu erkennen, und der ferner konfiguriert ist, um ein Aus-Signal (OV_off, C_off) auszugeben, wenn die Eingangsspannung (Vcc) unter einer Schwellenspannung liegt,
wobei der Schalter (510, 610, 710) ferner konfiguriert ist, um durch das Aus-Signal (OV_off, C_off) ausgeschaltet zu werden, und
wobei der Spannungsregler (512) und der weitere Komparator (506, 606, 706) ausgeschaltet werden, wenn der Schalter (510, 610, 710) ausgeschaltet wird.

2. Elektronische Schaltung (500, 600, 700) nach Anspruch 1, ferner umfassend eine Schnellentladungsschaltung (614, 714), die konfiguriert ist, um eine Gate-Source-Kapazität des Transistorschalters (502, 602, 702) schnell zu entladen, wobei die Schnellentladungsschaltung konfiguriert ist, um zu Beginn eines Überspannungsereignisses, das durch das Ein-Signal (V_on, C_on) ausgelöst wird, aktiv zu sein.

3. Elektronische Schaltung (500, 600, 700) nach einem der vorstehenden Ansprüche, ferner umfassend einen Unterschwingungsschutztransistor (M4), wobei ein Drain des Unterschwingungsschutztransistors (M4) mit der Eingangsspannung (Vcc) verbunden ist, wobei eine Source des Unterschwingungsschutztransistors (M4) über den Schalter (510, 610, 710) mit dem Gate des Transistorschalters (502, 602, 702) verbunden ist, und wobei ein Gate des Unterschwingungsschutztransistors (M4) mit der Klemmspannung (Vclamp) verbunden ist.

4. Elektronische Schaltung (500, 600, 700) nach einem der Ansprüche 1 bis 3, wobei der Transistorschalter (502, 60, 702) ein NMOST-Schalter ist.

5. Elektronische Schaltung (500, 600, 700) nach einem der Ansprüche 1 bis 3, wobei der Transistorschalter (502, 60, 702) ein PMOST-Schalter ist.

6. Elektronische Schaltung (500, 600, 700) nach einem der vorstehenden Ansprüche, wobei der Überspannungskomparator (508, 608, 708) und der weitere Komparator (506, 606, 706) Schmitt-Trigger-Komparatoren sind.

7. Elektronische Schaltung (500, 600, 700) nach einem der vorstehenden Ansprüche, wobei das Gate des Transistorschalters (502, 602, 702) mit einer Ladungspumpe (504) verbunden ist, wobei die Ladungspumpe (504) unabhängig von dem Schalter (510, 610, 710) arbeitet.

8. Elektronische Schaltung (500, 600, 700) nach einem der vorstehenden Ansprüche, wobei die elektronische Schaltung (500, 600, 700) ein Teil einer eFuse-Schaltung zum Überspannungsschutz einer elektronischen Last ist, wobei die eFuse-Schaltung konfiguriert ist, um durch den Schalter (510, 610, 710) unter Steuerung des Ein-Signals (OV_on, C_on) und des Aus-Signals (OV_off, C_off) ein- und ausgeschaltet wird, mit Ausnahme des Überspannungskomparators (508, 608, 708), der unabhängig davon aktiv ist, ob der Schalter (510, 610, 710) ein- oder ausgeschaltet ist.

9. Elektronische Vorrichtung (800), umfassend eine elektronische Schaltung (500, 600, 700) und einen Transistorschalter (502, 602, 702) nach einem der Ansprüche 1 bis 8.

## Revendications

1. Circuit électronique (500, 600, 700) de protection contre les surtensions d'un commutateur à transistor (502, 602, 702), comprenant :
un comparateur de surtension (508, 608, 708) conçu pour détecter une surtension sur une source de tension (Vsource) du commutateur à transistor (502, 602, 702) en comparant la tension source (Vsource) à une tension de référence (Vref), et en outre conçu pour émettre un signal d'activation (OV_on, C_on) quand une surtension est détectée ;
un commutateur (510, 610, 710) conçu pour être commuté actif par le signal d'activation (OV_on, C_on) ;
un régulateur de tension (512) conçu pour réguler une tension de blocage (Vclamp) quand le commutateur (510, 610, 710) est commuté actif, la tension de blocage (Vclamp) régulant une tension de grille (Vgate) sur une grille du commutateur à transistor (502, 602, 702) ; et
un autre comparateur (506, 606, 706) conçu pour détecter une tension d'entrée (Vcc) du commutateur à transistor (502, 602, 702), et en outre conçu pour émettre un signal de désactivation (OV_off, C_off) quand la tension d'entrée (Vcc) est inférieure à une tension seuil,
dans lequel le commutateur (510, 610, 710) est en outre conçu pour être commuté inactif par le signal de désactivation (OV_off, C_off), et
dans lequel le régulateur de tension (512) et l'autre comparateur (506, 606, 706) sont commutés inactifs quand le commutateur (510, 610, 710) est désactivé.

2. Circuit électronique (500, 600, 700) selon la revendication 1, comprenant en outre un circuit de décharge rapide (614, 714) conçu pour décharger rapidement un condensateur de grille-source du commutateur à transistor (502, 602, 702), le circuit de décharge rapide étant conçu pour être actif au début d'un événement de surtension déclenché par le signal d'activation (V_on, C_on).

3. Circuit électronique (500, 600, 700) selon l'une quelconque des revendications précédentes, comprenant en outre un transistor de protection contre les sous dépassements (M4), un drain du transistor de protection contre les sous dépassements (M4) étant relié à la tension d'entrée (Vcc), une source du transistor de protection contre les sous dépassements (M4) étant reliée à la grille du commutateur à transistor (502, 602, 702) par l'intermédiaire du commutateur (510, 610, 710), et une grille du transistor de protection contre les sous dépassements (M4) étant reliée à la tension de blocage (Vclamp).

4. Circuit électronique (500, 600, 700) selon l'une quelconque des revendications 1 à 3, dans lequel le commutateur à transistor (502, 60, 702) est un commutateur NMOST.

5. Circuit électronique (500, 600, 700) selon l'une quelconque des revendications 1 à 3, dans lequel le commutateur à transistor (502, 60, 702) est un commutateur PMOST.

6. Circuit électronique (500, 600, 700) selon l'une quelconque des revendications précédentes, dans lequel le comparateur de surtensions (508, 608, 708) et l'autre comparateur (506, 606, 706) sont des comparateurs à bascule de Schmitt.

7. Circuit électronique (500, 600, 700) selon l'une quelconque des revendications précédentes, dans lequel la grille du commutateur à transistor (502, 602, 702) est reliée à une pompe de charge (504), la pompe de charge (504) fonctionnant indépendamment du commutateur (510, 610, 710).

8. Circuit électronique (500, 600, 700) selon l'une quelconque des revendications précédentes, dans lequel le circuit électronique (500, 600, 700) constitue une partie d'un circuit de fusible électronique de protection contre les surtensions d'une charge électronique, le circuit de fusible électronique étant conçu pour être commuté actif et inactif par le commutateur (510, 610, 710) sous l'effet d'une commande du signal d'activation (OV_on, C_on) et du signal de désactivation (OV_off, C_off), à l'exception du comparateur de surtension (508, 608, 708) qui est actif que le commutateur (510, 610, 710) soit actif ou inactif.

9. Dispositif électronique (800) comprenant un circuit électronique (500, 600, 700) et un commutateur à transistor (502, 602, 702) selon l'une quelconque des revendications 1 à 8.
